# EUROPEAN PATENT SPECIFICATION

(11) **EP 2 983 212 B1**
(45) Date of publication and mention of the grant of the patent: **04.11.2020**
(21) Application number: 15002283.8
(22) Date of filing: 31.07.2015
(51) Int. Cl.: H01L 31/048, H01L 31/05, H01L 31/02, H05K 3/32

(54) **SOLAR CELL MODULE**
SOLARZELLENMODUL
MODULE DE CELLULE SOLAIRE

(30) Priority: 04.08.2014 KR 20140099711; 21.07.2015 KR 20150103025
(43) Date of publication of application: 10.02.2016
(73) Proprietor: LG Electronics Inc., Yeongdeungpo-gu Seoul 150-721 (KR)
(72) Inventor: LIM, Chunghyun, 153-802 Seoul (KR); KIM, Minpyo, 153-802 Seoul (KR)
(74) Representative: Frenkel, Matthias Alexander

(56) References cited:
- EP-A1- 2 966 693
- WO-A1-2014/119252
- WO-A2-2012/037191
- KR-A- 20100 123 163
- US-A1- 2009 255 565
- US-A1- 2009 277 006
- US-A1- 2013 240 022
- US-A1- 2014 213 013

## Description

### Field of the Invention

Embodiments of the invention relate to a solar cell module including a plurality of solar cells.

### Description of the Related Art

A solar cell generally includes a substrate and an emitter region, which are formed of semiconductors of different conductive types, for example, a p-type and an n-type, and electrodes respectively connected to the substrate and the emitter region. A p-n junction is formed at an interface between the substrate and the emitter region.

When light is incident on the solar cell, electrons inside the semiconductor become free electrons (hereinafter referred to as "electrons") by photoelectric effect. Further, electrons and holes respectively move to an n-type semiconductor (for example, the emitter layer) and a p-type semiconductor (for example, the substrate) based on a principle of the p-n junction. Then, the electrons and the holes are collected by the electrodes electrically connected to the emitter region and the substrate.

In recent times, an interdigitated back contact solar cell, in which electrodes are not formed on a light receiving surface of a semiconductor substrate, but are formed on a back surface of the semiconductor substrate, has been developed to increase the efficiency of the solar cell.

Further, a module technology for electrically connecting the plurality of solar cells has been developed. Examples of the module technology include a method for electrically connecting the plurality of solar cells using ribbon-shaped wires or clip-shaped wires.

WO 2014/119252 A1 discloses a solar cell module in which an insulating adhesive portion is positioned between two solar cells and extends in the same direction as the interconnectors.

KR 2010 0123163 A discloses an insulating adhesive portion positioned between two solar cells and extending in the same direction as the interconnectors.

US 2013/240022 A1 discloses a solar cell module in which the first insulation layer and the second insulation layer are positioned between the ribbon (interconnector) and the solar cells.

EP 2 966 693 A1 (relevant according to Article 54(3) EPC) discloses a solar cell module, in which first and second wiring members are fixed to the solar cells using a tape so that they do not move, wherein the tape can be liquid tape based on any epoxy-based synthetic resin or a silicon-based synthetic resin or a solid tape.

### SUMMARY OF THE INVENTION

Embodiments of the invention provide a solar cell module with more improved efficiency, in which the number of manufacturing processes is reduced.

A solar cell module according to the present invention is defined in claim 1. Preferred features are defined in the dependent claims. In one aspect useful for understanding the invention, there is a solar cell module including a plurality of solar cells each including a semiconductor substrate and first and second electrode parts each having a different polarity, a plurality of interconnectors configured to electrically connect the plurality of solar cells, a conductive adhesive configured to electrically connect each of the plurality of interconnectors to the corresponding electrode part of each of the plurality of solar cells, and at least one insulating adhesive portion configured to temporarily fix the plurality of interconnectors to the corresponding electrode part, wherein the at least one insulating adhesive portion includes an adhesive having adhesiveness to attach the interconnector to the corresponding electrode part at the room temperature.

For example, the insulating adhesive portion may be a pressure sensitive adhesive tape.

Thus, the interconnector may be attached to the corresponding electrode part using the insulating adhesive portion including the adhesive without performing the curing process.

The insulating adhesive portion is formed of a single-sided tape, of which one side has the adhesive.

The insulating adhesive portion formed of the single-sided tape is positioned on the plurality of interconnectors so that the adhesive faces the semiconductor substrate.

The plurality of solar cells may be positioned adjacent to each other along a first direction, and the plurality of interconnectors extends in the first direction.

In this instance, the insulating adhesive portion may include a first tape positioned at one area of the semiconductor substrate and a second tape positioned at an opposite area to the one area of the semiconductor substrate. The first tape and the second tape may extend in a second direction crossing the first direction.

The at least one insulating adhesive portion may include a third tape positioned between the one area and the opposite area of the semiconductor substrate, in addition to the first and second tapes.

A width of the at least one insulating adhesive portion may be greater than a width of the interconnector. On the contrary, the width of the at least one insulating adhesive portion may be equal to or less than the width of the interconnector.

At least one of the first tape and the second tape may be divided into a plurality of parts along the second direction.

The conductive adhesive may include a resin cured by heat or light and a plurality of conductive particles distributed in the resin.

In this instance, the plurality of interconnectors may be formed of a conductive metal or a conductive metal and a solder coated on the surface of the conductive metal. When the plurality of interconnectors are formed of the conductive metal, the conductive metal may directly contact the adhesive of the insulating adhesive portion. When the plurality of interconnectors includes the solder, the solder may directly contact the adhesive of the insulating adhesive portion.

On the contrary, when the plurality of interconnectors are formed of the conductive metal and the solder coated on the surface of the conductive metal, the solder may serve as the conductive adhesive without using a separate conductive adhesive. In this instance, it is preferable, but not required, that the solder is formed of a low melting point solder having a melting temperature equal to or lower than 180 °C.

The first and second electrode parts are positioned on the same surface of the semiconductor substrate.

In this instance, the first electrode part may include first finger electrodes extending in the first direction, and the second electrode part may include second finger electrodes extending in the first direction. An interconnector connected to the first electrode part of one solar cell may be connected to the second electrode part of an adjacent solar cell, and another interconnector connected to the second electrode part of the one solar cell is connected to the first electrode part of another adjacent solar cell.

At least one of the first tape and the second tape may overlap or may not overlap at least one of the first finger electrode and the second finger electrode on a projected surface of the semiconductor substrate.

On the contrary, the first electrode part may include first finger electrodes extending in the second direction, and the second electrode part may include second finger electrodes extending in the second direction. An interconnector connected to the first electrode part of one solar cell may be connected to the second electrode part of an adjacent solar cell, and another interconnector connected to the second electrode part of the one solar cell is connected to the first electrode part of another adjacent solar cell.

The interconnector electrically connected to the first electrode part of the first solar cell may be insulated from the second electrode part of the one solar cell by an insulating layer positioned in a portion crossing the second electrode part of the one solar cell. Further, the interconnector electrically connected to the second electrode part of the one solar cell may be insulated from the first electrode part of the one solar cell by an insulating layer positioned in a portion crossing the first electrode part of the one solar cell.

When the finger electrodes have the electrode structure arranged in a direction crossing an extending direction of the interconnector as described above, the interconnector electrically connected to the first electrode part of the one solar cell may be insulated from and attached to the second electrode part of the one solar cell by the insulating adhesive portion positioned in a portion crossing the second electrode part of the one solar cell. Further, the interconnector electrically connected to the second electrode part of the one solar cell may be insulated from and attached to the first electrode part of the one solar cell by the insulating adhesive portion positioned in a portion crossing the first electrode part of the one solar cell.

Because the solar cell module having the above-described configuration includes the insulating adhesive portion capable of temporarily fixing the interconnector to the corresponding electrode part without performing the separate curing process, the plurality of solar cells may be transferred to a lamination equipment in a state where the interconnector is temporarily fixed to the corresponding electrode part.

Thus, even if a tabbing process for electrically connecting the interconnector to the corresponding electrode part is not performed, the insulating adhesive portion may efficiently prevent an alignment state between the interconnector and the corresponding electrode part in a substrate transfer process for performing a lamination process from being damaged.

Because the tabbing process for electrically attaching the interconnector to the corresponding electrode part using the conductive adhesive is performed by heat applied to the solar cell module during the lamination process, the tabbing process does not need to be separately performed before the substrate transfer process for performing the lamination process. Thus, the manufacturing process of the solar cell module may be simplified.

Because the tabbing process for the interconnector and the corresponding electrode part is performed during the lamination process, a bowing phenomenon of the substrate may be prevented as compared to when the tabbing process is separately performed before the lamination process.

Because the interconnector is locally fixed using the insulating adhesive portion, an amount of material used in the embodiment of the invention may be reduced as compared to a case of fixing all of a plurality of interconnectors at once by applying an adhesive to one surface of an insulating substrate having the size equal or larger than a semiconductor substrate. Thus, the manufacturing cost may be reduced.

The fact that the interconnector is locally fixed using the insulating adhesive portion means that not the entire area but a partial area of the interconnector on the projected surface is fixed by the insulating adhesive portion.

As described above, because the insulating adhesive portion may locally fix the partial area of the interconnector, it is preferable, but not required, that the entire flat size of the insulating adhesive portion is less than the entire flat size of the semiconductor substrate.

For example, the entire flat size of the insulating adhesive portion may be equal to or less than 0.5 times, preferably, 0.2 times, more preferably, 0.1 times of the entire flat size of the semiconductor substrate.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 illustrates a solar cell module according to a first embodiment of the invention;
FIG. 2 is a cross-sectional view of a portion "A" shown in FIG. 1;
FIG. 3 is a cross-sectional view of a portion "B" shown in FIG. 1;
FIG. 4 illustrates a modified embodiment of FIG. 1 not forming part of the invention;
FIG. 5 is a cross-sectional view of a portion "C" shown in FIG. 4;
FIG. 6 shows an example of an interdigitated back contact solar cell applicable to the solar cell module shown in FIG. 1;
FIG. 7 shows an example where an insulating paste is applied to a back surface of the interdigitated back contact solar cell shown in FIG. 6;
FIG. 8 illustrates a solar cell module not forming part of the invention;
FIG. 9 shows a state where an insulating adhesive portion is attached to a back surface of an interdigitated back contact solar cell shown in FIG. 8;
FIG. 10 illustrates a solar cell module not forming part of the invention;
FIG. 11 illustrates a modified embodiment of FIG. 10; and
FIG. 12 is a cross-sectional view of a portion "D" shown in FIG. 11.
FIG. 13 shows an example of adjusting the number of insulating adhesive portions unlike FIG. 1;
FIG. 14 shows an example where an insulating adhesive portion is divided into a plurality of insulating adhesive portions in a second direction unlike FIG. 1; and
FIG. 15 illustrates a solar cell module according to a second embodiment of the invention.

### DETAILED DESCRIPTION OF THE EMBODIMENTS

Reference will now be made in detail to embodiments of the invention examples of which are illustrated in the accompanying drawings. Since the invention may be modified in various ways and may have various forms, specific embodiments are illustrated in the drawings and are described in detail in the specification. However, it should be understood that the invention are not limited to specific disclosed embodiments, but include all modifications, equivalents and substitutes included within the technical scope of the invention.

The terms 'first', 'second', etc., may be used to describe various components, but the components are not limited by such terms. The terms are used only for the purpose of distinguishing one component from other components.

For example, a first component may be designated as a second component without departing from the scope of the embodiments of the invention. In the same manner, the second component may be designated as the first component.

The term "and/or" encompasses both combinations of the plurality of related items disclosed and any item from among the plurality of related items disclosed.

When an arbitrary component is described as "being connected to" or "being linked to" another component, this should be understood to mean that still another component(s) may exist between them, although the arbitrary component may be directly connected to, or linked to, the second component.

On the other hand, when an arbitrary component is described as "being directly connected to" or "being directly linked to" another component, this should be understood to mean that no other component exists between them.

The terms used in this application are used to describe only specific embodiments or examples, and are not intended to limit the invention. A singular expression can include a plural expression as long as it does not have an apparently different meaning in context.

In this application, the terms "include" and "have" should be understood to be intended to designate that illustrated features, numbers, steps, operations, components, parts or combinations thereof exist and not to preclude the existence of one or more different features, numbers, steps, operations, components, parts or combinations thereof, or the possibility of the addition thereof.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Unless otherwise specified, all of the terms which are used herein, including the technical or scientific terms, have the same meanings as those that are generally understood by a person having ordinary knowledge in the art to which the invention pertains.

The terms defined in a generally used dictionary must be understood to have meanings identical to those used in the context of a related art, and are not to be construed to have ideal or excessively formal meanings unless they are obviously specified in this application.

The following example embodiments of the invention are provided to those skilled in the art in order to describe the invention more completely. Accordingly, shapes and sizes of elements shown in the drawings may be exaggerated for clarity.

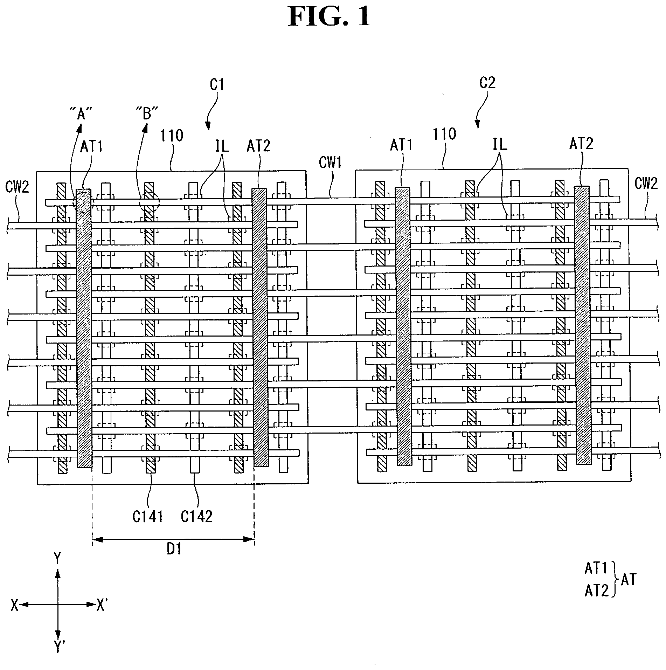

Exemplary embodiments of the invention will be described with reference to FIGS. 1 to 3, 6 to 7 and 13 to 15.

The following embodiments of the invention will describe an interdigitated back contact solar cell, in which both a first electrode part and a second electrode part each having a different polarity are positioned on a back surface of a semiconductor substrate. Other types of solar cells having various electrode structures may be used. For example, the embodiments of the invention may be applied to a metal wrap through (MWT) solar cell. Further, the embodiments of the invention may be applied to a typical solar cell having one light receiving surface, in which a first electrode part and a second electrode part are positioned on different surfaces of a semiconductor substrate, or a bifacial solar cell.

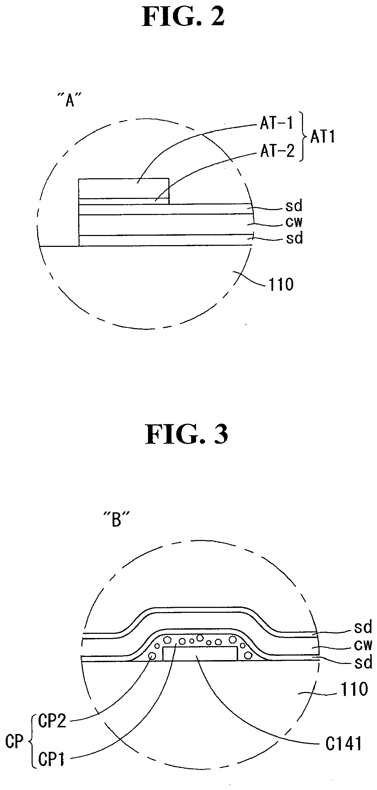

FIG. 1 illustrates a solar cell module according to a first embodiment of the invention. FIG. 2 is a cross-sectional view of a portion "A" shown in FIG. 1, and FIG. 3 is a cross-sectional view of a portion "B" shown in FIG. 1.

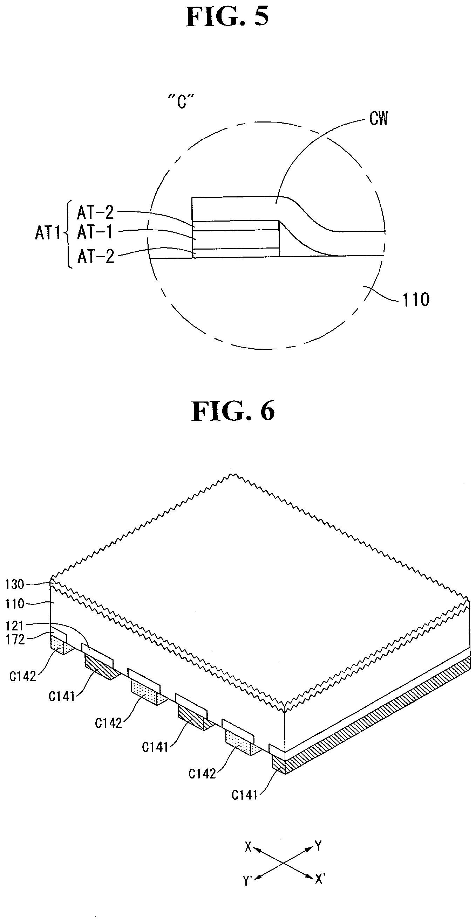

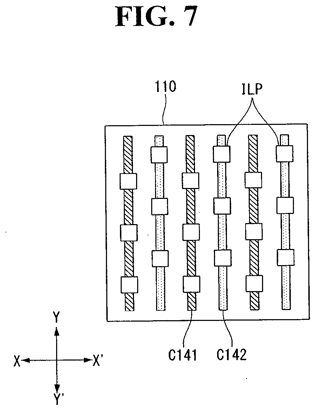

FIG. 6 shows an example of an interdigitated back contact solar cell applicable to the solar cell module shown in FIG. 1, and FIG. 7 shows an example where an insulating paste is applied to a back surface of the interdigitated back contact solar cell shown in FIG. 6.

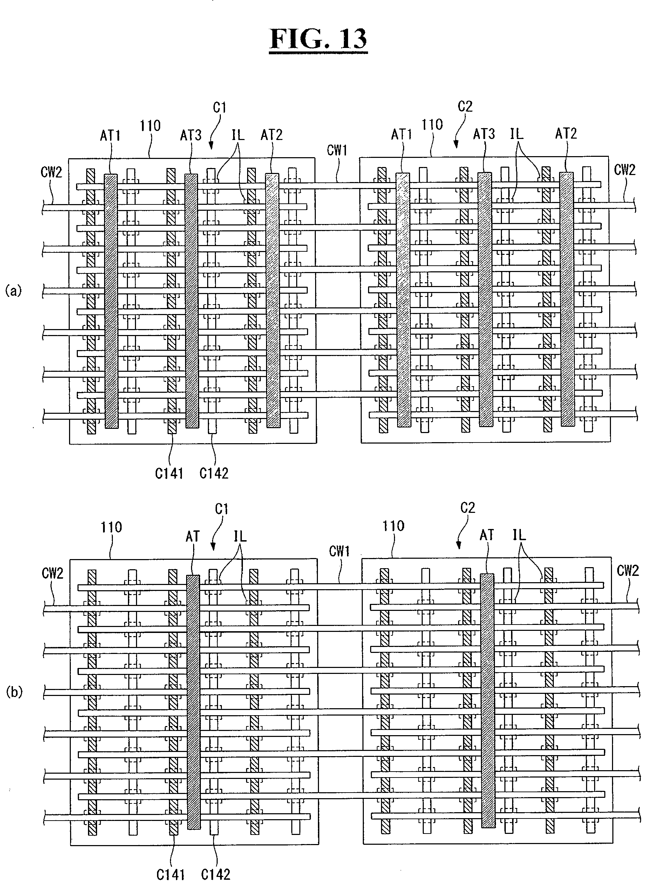

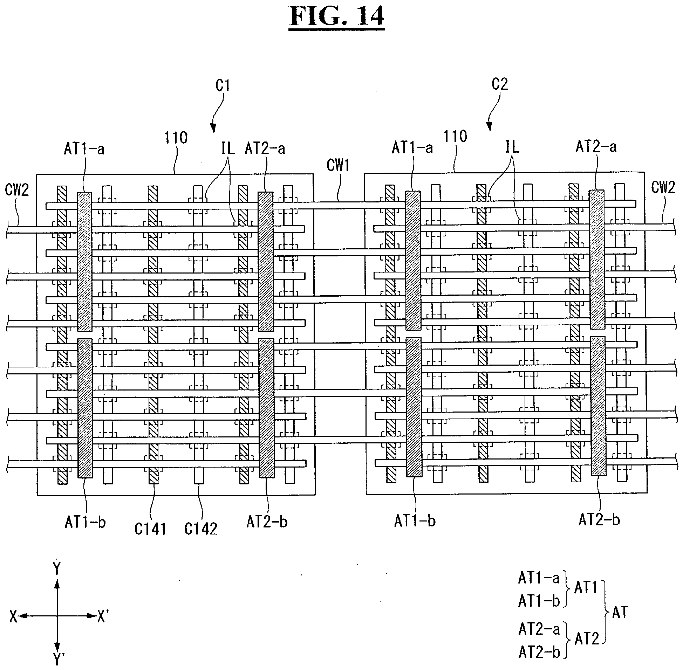

FIG. 13 shows an example of adjusting the number of insulating adhesive portions unlike FIG. 1, and FIG. 14 shows an example where an insulating adhesive portion is divided into a plurality of insulating adhesive portions in a second direction unlike FIG. 1.

As shown in FIG. 1, the solar cell module according to the first embodiment of the invention includes a first interdigitated back contact solar cell C1 and a second interdigitated back contact solar cell C2 which are alternately positioned in a first direction X-X', interconnectors CW1 and CW2 for electrically connecting the first and second interdigitated back contact solar cells C1 and C2 which are adjacent to each other, and an insulating adhesive portion AT positioned on a portion of a back surface of each of the first and second interdigitated back contact solar cells C1 and C2.

Each of the plurality of interdigitated back contact solar cells includes a semiconductor substrate 110, a first electrode part including a plurality of first finger electrodes C141, and a second electrode part including a plurality of second finger electrodes C142. The first electrode part and the second electrode part each have a non-busbar structure not including a busbar electrode for physically and electrically connecting the finger electrodes of each electrode part. Accordingly, the first electrode part and the second electrode part are connected to the interconnectors CW1 and CW2 extending in a second direction Y-Y', whereby the interconnector CW1 connects the first electrode part of the first solar cell C1 to the second electrode part of the second solar cell C1, and the interconnector CW2 connects the second electrode part of the first solar cell C1 to the first electrode part of a previous solar cell.

The semiconductor substrate 110 may contain crystalline silicon or amorphous silicon. A p-n junction may be formed in the semiconductor substrate 110, so as to produce electric power from light incident on the semiconductor substrate 110.

The first finger electrode C141 and the second finger electrode C142 may be positioned on a back surface of the semiconductor substrate 110 to be separated from each other in the first direction X-X'. The interdigitated back contact solar cell is described below in detail with reference to FIG. 6.

The interconnectors CW1 and CW2 electrically connect the plurality of solar cells including the first and second interdigitated back contact solar cells C1 and C2. As shown in FIGS. 2 and 3, the interconnectors CW1 and CW2 may be formed of a conductive metal cw (for example, a conductive wire of a circular cross section) formed of a metal (for example, copper (Cu) and silver (Ag)) with excellent conductivity and a solder sd coated on an external surface of the conductive metal cw. Alternatively, as shown in FIG. 5, the interconnectors CW1 and CW2 may be formed of only a conductive metal.

FIG. 1 shows that each of the number of interconnectors CW1 and the number of interconnectors CW2 are six, as an example. However, each of the number of interconnectors CW1 and the number of interconnectors CW2 may be ten to twenty.

The solder sd may be formed of a low melting point solder having a melting temperature equal to or lower than about 180 °C or a high melting point solder melted at a temperature higher than about 180 °C.

The conductive metal of the interconnectors CW1 and CW2 may generally have a rectangular cross section or a quadrangular cross section similar to a ribbon. Further, the conductive metal of the interconnectors CW1 and CW2 may have various shapes of the cross section, in addition to a circle and a quadrangle.

The interconnector is fixed and electrically connected to the corresponding electrodes using a conductive adhesive CP.

The conductive adhesive CP may be formed by curing a conductive paste, including a resin CP1 cured by heat or light and a plurality of conductive particles CP2 distributed in the resin CP1, using heat or light.

A material of the resin CP1 is not particularly limited as long as it has the adhesive properties through a curing process. It is preferable, but not required, that a thermosetting resin cured at a temperature lower than a lamination process temperature (for example, about 150 °C) is used so as to increase the adhesive reliability.

The thermosetting resin may use at least one selected among epoxy resin, phenoxy resin, acryl resin, polyimide resin, and polycarbonate resin.

The resin CP1 may contain a predetermined component, for example, a known curing agent and a known curing accelerator, in addition to the thermosetting resin.

For example, the resin CP1 may contain a reforming material, such as a silane-based coupling agent, a titanate-based coupling agent, and an aluminate-based coupling agent, so as to improve an adhesive strength between the corresponding electrode part and the interconnector. The resin CP1 may contain a dispersing agent, for example, calcium phosphate and calcium carbonate, so as to improve the dispersibility of the conductive particles CP2. The resin CP1 may contain a rubber component, such as acrylic rubber, silicon rubber, and urethane rubber, so as to control the modulus of elasticity.

A material of the conductive particles CP2 is not particularly limited as long as it has the conductivity. The conductive particles CP2 may contain at least one metal selected among copper (Cu), silver (Ag), gold (Au), iron (Fe), nickel (Ni), lead (Pb), zinc (Zn), cobalt (Co), titanium (Ti), and magnesium (Mg) as the main component. The conductive particles CP2 may be formed of metal particles or metal-coated resin particles.

The conductive particles CP2 may have various shapes including a flake shape, a burr shape, and a sphere shape.

It is preferable, but not required, that a composition amount of the conductive particles CP2 distributed in the resin CP1 is about 0.5 volume% to 20 volume% based on the total volume of the conductive adhesive CP in consideration of the connection reliability after the resin CP1 is cured.

When the composition amount of the conductive particles CP2 is less than about 0.5 volume%, the current may not smoothly flow because of a reduction in a physical contact area between the corresponding electrode part and the conductive particles CP2. When the composition amount of the conductive particles CP2 is greater than about 20 volume%, the adhesive strength between the corresponding electrode part and the interconnector may be reduced because an amount of the resin CP1 relatively decreases.

As shown in FIG. 3, the conductive adhesive CP having the above-described configuration may be locally applied only to an area required to be connected to the corresponding electrode part. However, an application position of the conductive adhesive CP is not particularly limited.

For example, as shown in FIG. 1, the conductive adhesive CP may be entirely applied to a remaining area excluding a formation area of an insulating layer IL from an area overlapping the interconnector on a projected surface along the longitudinal direction X-X' of the interconnector.

In the above-described solar cell module, the first and second interdigitated back contact solar cells C1 and C2 may be arranged in a direction crossing a longitudinal direction of the first and second finger electrodes C141 and C142 of each of the first and second interdigitated back contact solar cells C1 and C2.

For example, as shown in FIG. 1, the longitudinal direction of the first and second finger electrodes C141 and C142 of each of the first and second interdigitated back contact solar cells C1 and C2 may be a second direction Y-Y', and the first and second interdigitated back contact solar cells C1 and C2 may be arranged in the first direction X-X'.

Further, a longitudinal direction of the plurality of interconnectors CW1 and CW2 may be a direction crossing the longitudinal direction Y-Y' of the first and second finger electrodes C141 and C142 of each of the first and second interdigitated back contact solar cells C1 and C2. For example, the longitudinal direction of the plurality of interconnectors CW1 and CW2 may be the first direction X-X'.

The plurality of interconnectors CW1 and CW2 may include a first interconnector CW1 connected to the first finger electrodes C141 of the first interdigitated back contact solar cell C1 and a second interconnector CW2 connected to the second finger electrodes C142 of the first interdigitated back contact solar cell C1.

The first interconnector CW1 may be connected to the second finger electrodes C142 of the second interdigitated back contact solar cell C2, and the second interconnector CW2 may be connected to the first finger electrodes C141 of the second interdigitated back contact solar cell C2. Hence, the plurality of interconnectors CW1 and CW2 may electrically connect the first and second interdigitated back contact solar cells C1 and C2.

The first interconnector CW1 may be electrically insulated from the second finger electrodes C142 of the first interdigitated back contact solar cell C1 by the insulating layer IL positioned in a portion crossing the second finger electrodes C142 of the first interdigitated back contact solar cell C1. Further, the first interconnector CW1 may be electrically insulated from the first finger electrodes C141 of the second interdigitated back contact solar cell C2 by the insulating layer IL positioned in a portion crossing the first finger electrodes C141 of the second interdigitated back contact solar cell C2.

The second interconnector CW2 may be electrically insulated from the first finger electrodes C141 of the first interdigitated back contact solar cell C1 by the insulating layer IL positioned in a portion crossing the first finger electrodes C141 of the first interdigitated back contact solar cell C1. Further, the second interconnector CW2 may be electrically insulated from the second finger electrodes C142 of the second interdigitated back contact solar cell C2 by the insulating layer IL positioned in a portion crossing the second finger electrodes C142 of the second interdigitated back contact solar cell C2.

The insulating layer IL may contain an insulating resin such as a resin (for example, an epoxy resin) cured by heat or light.

The above embodiment of the invention described that the interconnectors CW1 and CW2 are directly connected to the electrodes of the two adjacent solar cells so as to connect the plurality of interdigitated back contact solar cells in series, as an example. On the contrary, each solar cell may include the interconnectors CW1 and CW2. In this instance, a separate interconnector may be used.

Namely, the interconnectors CW1 and CW2 may be positioned on the back surface of each interdigitated back contact solar cell, and the interconnectors CW1 and CW2 may be connected to the separate interconnector. Hence, the plurality of solar cells may be electrically connected.

The insulating adhesive portion AT may be used to temporarily fix the plurality of interconnectors CW1 and CW2 to the back surfaces of the semiconductor substrates 110.

The insulating adhesive portion AT may be formed using an insulating adhesive paste or an insulating adhesive tape.

More specifically, as shown in FIG. 1, when the insulating adhesive paste is used as the insulating adhesive portion AT, the insulating adhesive portion AT may be formed by disposing the plurality of interconnectors CW1 and CW2 on the back surfaces of the semiconductor substrates 110 and then drying it in a state where the insulating adhesive paste used as the insulating adhesive portion AT is applied. Alternatively, the insulating adhesive portion AT may be formed by disposing the plurality of interconnectors CW1 and CW2 in a state where the insulating adhesive paste used as the insulating adhesive portion AT is applied to the back surfaces of the semiconductor substrates 110, and then drying it.

Further, when the insulating adhesive tape is used as the insulating adhesive portion AT, the insulating adhesive portion AT may have a tape configuration. In the following description, the embodiment of the invention is described using the insulating adhesive tape as an example of the insulating adhesive portion AT.

When the insulating adhesive portion AT is configured as the insulating adhesive tape, the insulating adhesive tape is used to temporarily fix the plurality of interconnectors CW1 and CW2 to the back surfaces of the semiconductor substrates 110. The insulating adhesive tape may be formed of a single-sided tape including a film AT-1 and an adhesive AT-2 positioned on one surface of the film AT-1.

The adhesive AT-2 contains an adhesive material capable of attaching the interconnector to the corresponding electrode part at a room temperature. In the embodiment disclosed herein, the fact that the adhesive AT-2 attaches the interconnector to the corresponding electrode part at the room temperature (for example, 1 °C to 35 °C) means that a separate process for curing the adhesive is not necessary.

Thus, the interconnector may be attached to the corresponding electrode part using the insulating adhesive portion AT including the adhesive AT-2 without performing the curing process.

For example, the insulating adhesive portion AT may be a pressure sensitive adhesive tape.

More specifically, the insulating adhesive portion AT may be melted or may not be melted through the lamination process involving the thermal process.

If the insulating adhesive portion AT is melted in the lamination process, the film AT-1 of the insulating adhesive portion AT may include polyolefin, and the adhesive AT-2 of the insulating adhesive portion AT may include at least one of acrylic, silicon, or epoxy.

If the insulating adhesive portion AT is not melted in the lamination process, the film AT-1 of the insulating adhesive portion AT may include at least one of polyethylene terephthalate (PET) or polyimide (PI), and the adhesive AT-2 of the insulating adhesive portion AT may include at least one of acrylic, silicon, or epoxy.

The insulating adhesive portion AT may further include a layer for blocking ultraviolet rays.

The insulating adhesive portion AT having the above-described configuration is positioned on the interconnector so that the adhesive AT-2 faces the semiconductor substrate 110, thereby temporarily fixing the interconnector to the semiconductor substrate 110.

Accordingly, even if a tabbing process for electrically connecting the interconnector to the corresponding electrode part is not performed, the insulating adhesive portion AT may efficiently prevent an alignment state between the interconnector and the corresponding electrode part in a substrate transfer process for performing a lamination process from being damaged.

As described above, the insulating adhesive portion AT may be used to locally (temporarily) fix the interconnectors CW1 and CW2 before the lamination process or before the tabbing process.

In the embodiment disclosed herein, the fact that the interconnector is locally fixed using the insulating adhesive portion AT means that not the entire area but a partial area of the interconnector on the projected surface is fixed by the insulating adhesive portion AT.

As described above, because the insulating adhesive portion AT may locally fix the partial area of the interconnector, it is preferable, but not required, that the entire flat size of the insulating adhesive portion AT is less than the entire flat size of the semiconductor substrate 110.

For example, the entire flat size of the insulating adhesive portion AT may be equal to or less than 0.5 times, preferably, 0.2 times, more preferably, 0.1 times of the entire flat size of the semiconductor substrate 110.

An amount of material used in the embodiment of the invention, in which the interconnector is locally fixed using the insulating adhesive portion AT as describe above, may be reduced as compared to a related art for fixing all of a plurality of interconnectors at once by applying an adhesive to one surface of an insulating substrate having the size equal or larger than a semiconductor substrate. Further, the embodiment of the invention may suppress the generation of a void and thus may increase a thickness of the interconnector.

Further, in the embodiment of the invention, because the tabbing process for electrically attaching the interconnector to the corresponding electrode part using the conductive adhesive is performed by heat applied to the solar cell module during the lamination process, the tabbing process does not need to be separately performed before the substrate transfer process for performing the lamination process. Thus, the manufacturing process of the solar cell module may be simplified.

Because the tabbing process for the interconnector and the corresponding electrode part is performed during the lamination process, the embodiment of the invention may prevent a bowing phenomenon of the substrate as compared to when the tabbing process is separately performed before the lamination process.

According to an experiment conducted by the inventors, when the interconnectors CW1 and CW2 were (temporarily) fixed at ends of the interconnectors CW1 and CW2, the interconnector was well fixed to the solar cell in the substrate transfer process for performing the lamination process.

Accordingly, in the embodiment of the invention, the insulating adhesive portions AT may include a first tape AT1 and a second tape AT2 which are respectively disposed at both areas of the semiconductor substrate 110 to be separated from each other by a distance D1 in the longitudinal direction (i.e., the first direction X-X') of the interconnector and extend in the second direction Y-Y'.

Further, at least one tape may be additionally disposed between the first tape AT1 and the second tape AT2.

For example, the insulating adhesive portion AT may further include a third tape AT3 positioned between both areas of the semiconductor substrate 110.

For example, as shown in (a) of FIG. 13, the insulating adhesive portion AT according to the embodiment of the invention may further include the third tape AT3 positioned in the middle of an area between the first and second tapes AT1 and AT2, in addition to the first and second tapes AT1 and AT2 respectively positioned in both areas of the semiconductor substrate 110.

Unlike (a) of FIG. 13, FIG. 1 shows that the insulating adhesive portion AT includes the first and second tapes AT1 and AT2 respectively in both areas of each solar cell, as an example. However, as shown in (b) of FIG. 13, only one insulating adhesive portion AT may be disposed in the middle of each solar cell in a state where the interconnectors CW1 and CW2 are disposed on the back surface of each solar cell, and may temporarily fix the interconnectors CW1 and CW2 to the back surface of each solar cell.

It is preferable, but not required, that a width of each of the insulating adhesive portions AT1, AT2, and AT3 is greater than a width of each of the interconnectors CW1 and CW2 considering that the interconnectors CW1 and CW2 are temporarily fixed in the manufacturing process. However, the width of each of the insulating adhesive portions AT1, AT2, and AT3 may be equal to or less than the width of each of the interconnectors CW1 and CW2.

Hence, the interconnectors CW1 and CW2 can be more stably fixed before the lamination process when the solar cell module is manufactured, and the manufacturing process of the solar cell module may be more easily performed.

At least one of the first tape AT1 and the second tape AT2 may be divided into a plurality of parts along the second direction Y-Y'.

For example, as shown in FIG. 14, the first tape AT1 may include a 1a tape AT1-a and a 1b tape AT1-b which are divided from the first tape AT1 along the second direction Y-Y' and are separated from each other. Further, the second tape AT2 may include a 2a tape AT2-a and a 2b tape AT2-b which are divided from the second tape AT2 along the second direction Y-Y' and are separated from each other.

For example each of the first tape AT1 and the second tape AT2 may be divided in various shapes within the range of a sum of the total number of first and second interconnectors CW1 and CW2. When the number of first tapes AT1 and the number of second tapes AT2 are equal to the sum of the total number of first and second interconnectors CW1 and CW2, one insulating adhesive portion may be used to temporarily fix one interconnector.

The first tape AT1 and the second tape AT2 may overlap at least a portion of the finger electrodes C141 and C142 on the projected surface, or may not overlap the finger electrodes C141 and C142.

As shown in FIG. 6, the interdigitated back contact solar cell may include the semiconductor substrate 110, an anti-reflection layer 130, an emitter region 121, a back surface field (BSF) region 172, the plurality of first finger electrodes C141, and the plurality of second finger electrodes C142.

The anti-reflection layer 130 and the back surface field region 172 may be omitted in the embodiment disclosed herein. However, the embodiment of the invention is described using the interdigitated back contact solar cell including the anti-reflection layer 130 and the back surface field region 172 as an example.

The semiconductor substrate 110 may be a semiconductor substrate formed of silicon of a first conductive type, for example, n-type silicon, though not required. The semiconductor substrate 110 may be formed by doping a semiconductor wafer formed of crystalline silicon with impurities of the first conductive type.

The emitter region 121 is positioned to be separated from one another at the back surface opposite the front surface of the semiconductor substrate 110 and extends in parallel with one another. Namely, the plurality of emitter regions 121 may be formed. The plurality of emitter regions 121 may contain impurities of a second conductive type (for example, p-type) opposite the first conductive type of the semiconductor substrate 110.

Hence, the semiconductor substrate 110 and the emitter regions 121 may form a p-n junction.

The plurality of back surface field regions 172 may be positioned at the back surface of the semiconductor substrate 110. The plurality of back surface field regions 172 are formed to be separated from one another in a direction parallel to the plurality of emitter regions 121 and extend in the same direction as the plurality of emitter regions 121.

Accordingly, as shown in FIG. 6, the plurality of emitter regions 121 and the plurality of back surface field regions 172 may be alternately positioned at the back surface of the semiconductor substrate 110.

Each back surface field region 172 may be a region (for example, an n⁺⁺-type region) which is more heavily doped than the semiconductor substrate 110 with impurities of the same conductive type as the semiconductor substrate 110.

The plurality of first finger electrodes C141 may be physically and electrically connected to the plurality of emitter regions 121, respectively, and may be formed on the back surface of the semiconductor substrate 110 at the same position as the emitter regions 121 on the projected surface.

The plurality of second finger electrodes C142 may be formed on the back surface of the semiconductor substrate 110 at the same position as the back surface field regions 172 on the projected surface and may be physically and electrically connected to the semiconductor substrate 110 through the plurality of back surface field regions 172, respectively.

The first finger electrodes C141 and the second finger electrodes C142 may be physically and spatially separated from each other on the back surface of the semiconductor substrate 110 and may be electrically insulated from each other.

The plurality of first finger electrodes C141 may extend in the second direction Y-Y' and may be separated from one another in the first direction X-X' crossing the second direction Y-Y'.

The plurality of second finger electrodes C142 may extend in the second direction Y-Y' and may be separated from one another in the first direction X-X' crossing the second direction Y-Y' in the same manner as the first finger electrodes C141.

Further, the plurality of first and second finger electrodes C141 and C142 may be separated from each other and may be alternately arranged in the first direction X-X'.

The interdigitated back contact solar cell applied to the solar cell module according to the embodiment of the invention is not limited to the structure shown in FIG. 6 and may be variously changed.

For example, the first and second finger electrodes C141 and C142 may not extend in the second direction Y-Y', may be separated from each other in the second direction Y-Y', and may be arranged in a dot shape.

The interdigitated back contact solar cell may further include a first busbar electrode, which extends in the first direction X-X' and commonly connects all of the plurality of first finger electrodes C141 at one end of the second direction Y-Y' on the back surface of the semiconductor substrate 110. In the same manner as the first busbar electrode, the interdigitated back contact solar cell may further include a second busbar electrode, which extends in the first direction X-X' and commonly connects all of the plurality of second finger electrodes C142 at the other end of the second direction Y-Y' on the back surface of the semiconductor substrate 110.

As shown in FIG. 7, an insulating paste ILP may be used, so that the interconnectors CW1 and CW2 are electrically connected to the corresponding finger electrodes in the interdigitated back contact solar cell shown in FIG. 6.

For example, as shown in FIG. 7, the insulating paste ILP may be applied to the plurality of first and second finger electrodes C141 and C142 extending in the second direction Y-Y', so as to connect the first and second interconnectors CW1 and CW2 to the plurality of first finger electrodes C141 or the plurality of second finger electrodes C142 formed on the back surface of the semiconductor substrate 110.

Further, as shown in FIG. 1, after the first and second interconnectors CW1 and CW2 are aligned and disposed on the back surfaces of the corresponding finger electrodes and are temporarily fixed to the corresponding finger electrodes using the first and second tapes AT1 and AT2, the lamination process may be performed. Alternatively, after the tabbing process for attaching the first and second interconnectors CW1 and CW2 to the corresponding finger electrodes by locally applying heat to a partial area is performed, the lamination process may be performed.

In the embodiment disclosed herein, the partial area may be a remaining area except a formation area of the first and second tapes AT1 and AT2. For example, the partial area may be a center area of the semiconductor substrate 110 positioned between the first and second tapes AT1 and AT2.

On the contrary, the partial area may be an overlap area between the interconnector and the corresponding finger electrodes on the projected surface.

As described above, when the tabbing process is performed by locally applying heat only to the partial area, the interconnector is attached to the corresponding finger electrodes because the conductive adhesive CP positioned in the application area of the heat is melted and cured.

The solders sd of the interconnectors CW1 and CW2 positioned in the application area of the heat are melted by the heat, but the solders sd of the interconnectors CW1 and CW2 positioned in a non-application area of the heat are not melted.

Thus, the interconnectors CW1 and CW2 are fixed to the corresponding finger electrodes by the conductive adhesive CP and the solders sd in the application area of the heat and also are electrically connected to the corresponding finger electrodes

Hence, the interconnectors CW1 and CW2 are fixed to the corresponding finger electrodes, which have to be electrically connected to the interconnectors CW1 and CW2, using the conductive adhesive CP and the solders sd. Further, the interconnectors CW1 and CW2 are fixed to the corresponding finger electrodes, which do not have to be electrically connected to the interconnectors CW1 and CW2, using the insulating paste ILP.

When the tabbing process is locally performed, the interconnector is physically fixed by the insulating adhesive portion. Therefore, a movement of the interconnector is minimized, and the bowing phenomenon of the substrate is suppressed through the local tabbing process.

When the interconnector is temporarily fixed using the insulating adhesive portions AT1 and AT2, the conductive metal may directly contact the adhesive AT-2 of the insulating adhesive portion if the interconnector is formed of only the conductive metal cw. When the interconnector includes the solder sd, the solder sd may directly contact the adhesive AT-2 of the insulating adhesive portion.

The solar cell module according to the embodiment of the invention does not perform the separate tabbing process in a state where the interconnector is temporarily fixed to the corresponding electrode part of the solar cell using the insulating adhesive portions AT1 and AT2, and may immediately perform the lamination process.

More specifically, as shown in FIG. 3, the conductive adhesive CP is positioned in the overlap area between the corresponding electrode part and the interconnector on the projected surface. As described above, the conductive adhesive CP includes the resin CP1 cured by heat or light and the plurality of conductive particles CP2 distributed in the resin CP1. In particular, the resin CP1 is formed of a thermosetting resin cured at a temperature lower than the lamination process temperature (for example, about 150 °C) of the solar cell module.

Accordingly, even if the separate tabbing process is not performed, the interconnector may be electrically connected to the corresponding electrode part because the conductive adhesive CP is cured during the lamination process.

When the conductive adhesive CP is not used, the solder sd of the interconnector may be formed of the low melting point solder melted at a temperature equal to or lower than about 180 °C. In this instance, as described above, because the low melting point solder is melted and soldered during the lamination process, the interconnector may be electrically connected to the corresponding electrode part.

Accordingly, a method for manufacturing the solar cell module according to the embodiment of the invention may separately perform the tabbing process, but it is preferable, but not required, that the tabbing process is performed during the lamination process, so as to increase the production yield through a reduction in the number of manufacturing processes.

Further, as described above, when the tabbing process is performed during the lamination process, the bowing phenomenon of the solar cell generally generated during the tabbing process is suppressed.

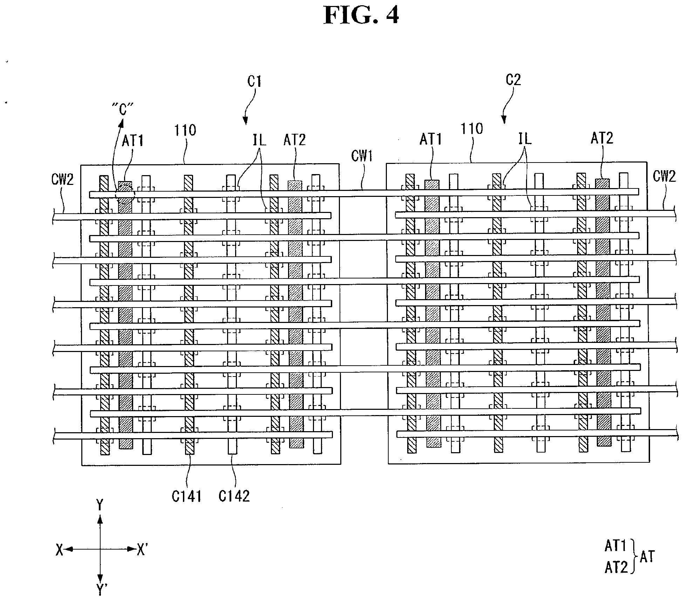

A modified embodiment of FIGS. 1 to 3 is described below with reference to FIGS. 4 and 5, which does not form part of the invention. Structures and components identical or equivalent to those illustrated in FIGS. 1 to 3 are designated with the same reference numerals, and a further description may be briefly made or may be entirely omitted.

In the solar cell module according to the modified embodiment, the insulating adhesive portions AT1 and AT2 include adhesives AT-2 on both surfaces of the film AT-1, unlike FIGS. 1 to 3.

Accordingly, because the interconnector is positioned on the corresponding electrode part and is temporarily fixed after the insulating adhesive portions AT1 and AT2 are attached to the back surface of the semiconductor substrate 110, the insulating adhesive portions AT1 and AT2 may be positioned between the interconnector and the semiconductor substrate 110, unlike FIGS. 1 to 3.

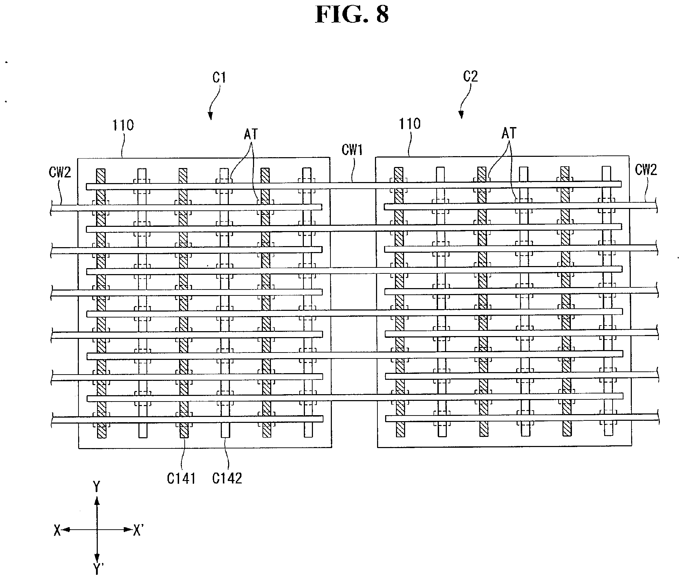

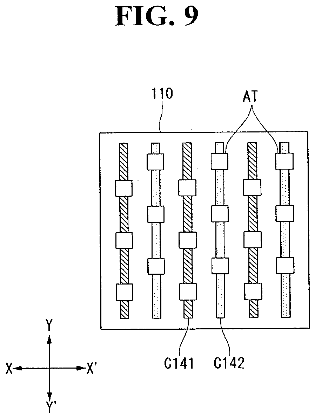

FIG. 8 illustrates a solar cell module not forming part of the invention, and FIG. 9 shows a state where an insulating adhesive portion is attached to a back surface of an interdigitated back contact solar cell shown in FIG. 8.

As shown in FIGS. 8 and 9, the solar cell module is characterized in that an insulating adhesive portion AT formed of a double-sided tape is positioned in a formation area of an insulating layer IL shown in FIGS. 1 to 3.

A separate insulating adhesive portion is not positioned at an edge of a semiconductor substrate 110.

However, the separate insulating adhesive portion may be positioned at the edge of the semiconductor substrate 110 in the same manner as the first embodiment of the invention illustrate in FIGS. 1 to 3.

In the solar cell module according to the second embodiment of the invention having the above-described configuration, an interconnector CW1 electrically connected to first finger electrodes C141 of a first solar cell C1 is electrically insulated from and attached to second finger electrodes C142 of the first solar cell C1 by the insulating adhesive portion AT positioned in a portion crossing the second finger electrodes C142 of the first solar cell C1. Further, an interconnector CW2 electrically connected to the second finger electrodes C142 of the first solar cell C1 is electrically insulated from and attached to the first finger electrodes C141 of the first solar cell C1 by the insulating adhesive portion AT positioned in a portion crossing the first finger electrodes C141 of the first solar cell C1.

Accordingly, because the electrical insulation may be achieved in an area requiring the electrical insulation without forming a separate insulating layer, the insulating layer used in the first embodiment of the invention may be removed in the second embodiment of the invention. Hence, the manufacturing process and the manufacturing cost may be reduced.

So far, the above embodiments of the invention described the solar cell module, in which the arrangement direction of the solar cells and the longitudinal direction of the interconnectors CW1 and CW2 cross the longitudinal direction of the first and second finger electrodes C141 and C142.

On the contrary, the arrangement direction of the solar cells and the longitudinal direction of the interconnectors CW1 and CW2 may be the same as the longitudinal direction of the first and second finger electrodes C141 and C142.

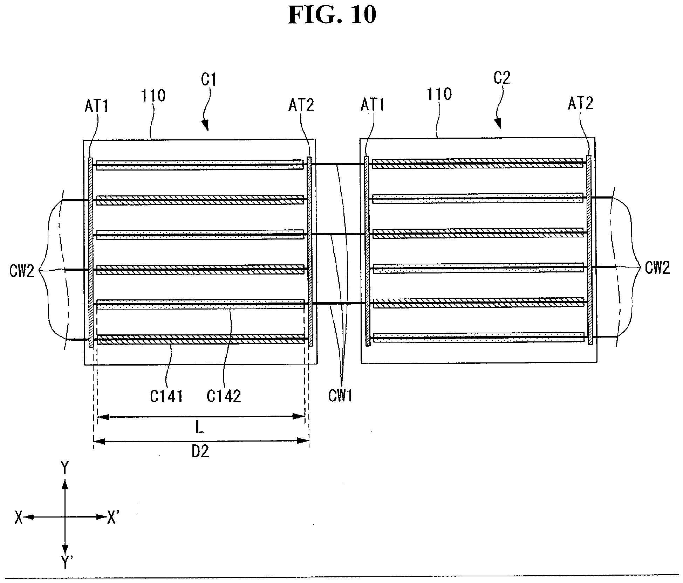

This is described with reference to FIG. 10. FIG. 10 illustrates a solar cell module not forming part of the invention.

Structures and components identical or equivalent to those illustrated in the first embodiment of the invention are designated with the same reference numerals, and a further description may be briefly made or may be entirely omitted.

FIG. 10, interconnectors CW1 and CW2 are indicated by the line for the simplification of the drawing.

In the solar cell module according to Fig. 10 an arrangement direction of interdigitated back contact solar cells C1 and C2 and a longitudinal direction of interconnectors CW1 and CW2 are the same direction (i.e., a first direction X-X') as a longitudinal direction of first and second finger electrodes C141 and C142.

Both the first and second finger electrodes C141 and C142 extend in the first direction X-X'. The interconnectors CW1 and CW2 electrically connect the first finger electrodes C141 of the first interdigitated back contact solar cell C1 to the first finger electrodes C141 of the second interdigitated back contact solar cell C2, or electrically connect the second finger electrodes C142 of the first interdigitated back contact solar cell C1 to the second finger electrodes C142 of the second interdigitated back contact solar cell C2.

A first tape AT1 and a second tape AT2 extending in a second direction Y-Y' crossing the first direction X-X' are positioned on a back surface of a semiconductor substrate 110 to be separated from each other by a distance D2 in the first direction X-X'.

The distance D2 between the first tape AT1 and the second tape AT2 in the first direction X-X' may be greater than a length L of the first and second finger electrodes C141 and C142. The first and second tapes AT1 and AT2 may be a single-sided tape or a double-sided tape.

As described above, when the distance D2 between the first and second tapes AT1 and AT2 in the first direction X-X' is greater than the length L of the first and second finger electrodes C141 and C142, each of the first and second tapes AT1 and AT2 does not overlap the first and second finger electrodes C141 and C142 on the projected surface. Thus, a contact area between the first and second finger electrodes C141 and C142 and the corresponding interconnector CW1 (or CW2) increases, and a carrier collection efficiency of the solar cell module is improved.

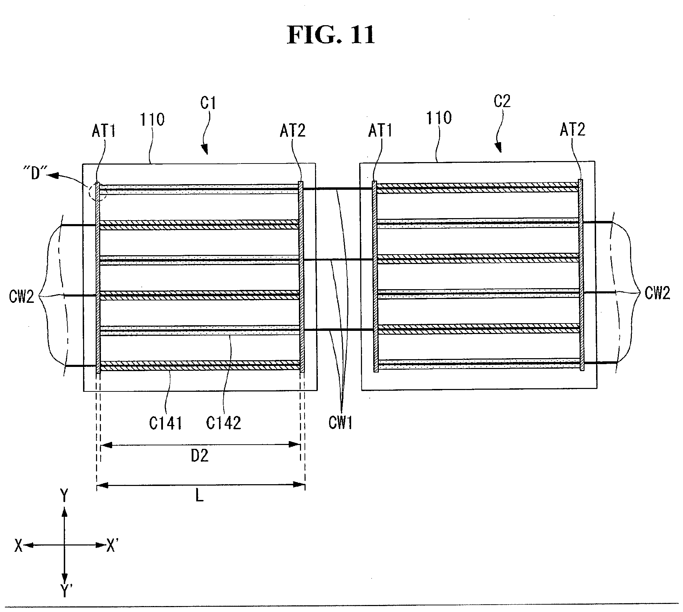

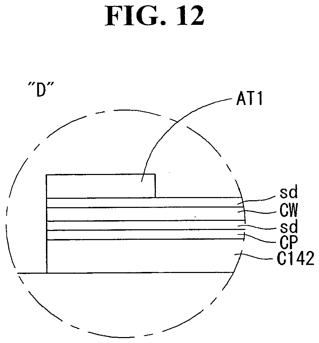

FIGS. 11 and 12 illustrate a modified embodiment of FIG. 10. More specifically, FIGS. 11 and 12 show that the distance D2 between the first and second tapesAT1 and AT2 in the first direction X-X' is less than the length L of the first and second finger electrodes C141 and C142, unlike the third embodiment of the invention shown in FIG. 10.

In this instance, at least one of the first and second tapes AT1 and AT2 may overlap at least one of the first and second finger electrodes C141 and C142 on the projected surface.

So far, the embodiments of the inventions described the use of the insulating adhesive portion as an example. However, any adhesive having an insulation property other than the insulating adhesive portion may be used.

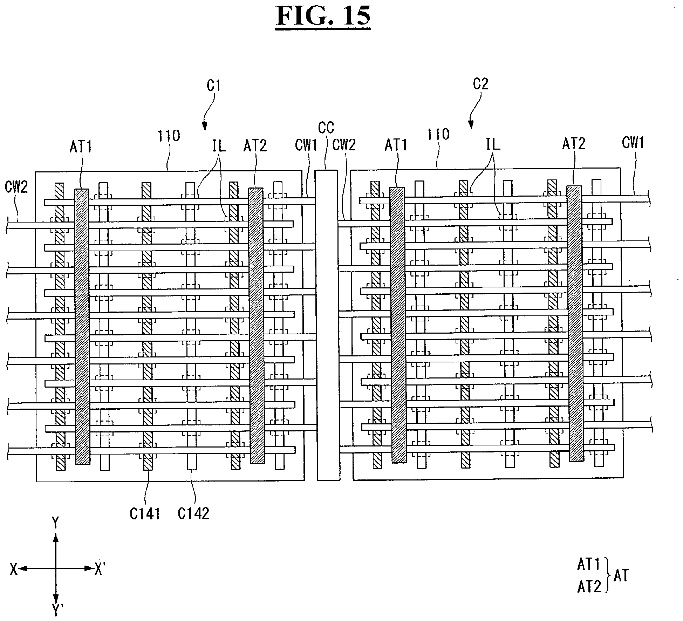

FIG. 15 illustrates a solar cell module according to a second embodiment of the invention.

The first embodiment of the invention is configured such that each of the interconnectors CW1 and CW2 has the length overlapping both the two adjacent solar cells, and each of the interconnectors CW1 and CW2 is connected to the first finger electrodes C141 or the second finger electrodes C142 of each solar cell.

For this, referring to FIG. 1, the first interconnector CW1 has the length overlapping both the first solar cell C1 and the second solar cell C2. Thus, the first interconnector CW1 is electrically connected to the first finger electrodes C141 of the first solar cell C1 using the conductive adhesive CP and is electrically connected to the second finger electrodes C142 of the second solar cell C2 using the conductive adhesive CP.

On the contrary, as shown in FIG. 15, in the solar cell module according to the second embodiment of the invention, each of the first and second interconnectors CW1 and CW2 may overlap only one solar cell and may be electrically connected to one solar cell using the conductive adhesive CP. The first and second interconnectors CW1 and CW2 may be connected in series to each other through an intercell connector CC which is positioned between the two adjacent solar cells and extends in the second direction Y-Y'.

More specifically, the first interconnector CW1 may be electrically connected to the first finger electrodes C141 of each solar cell using the conductive adhesive CP and may be insulated from the second finger electrodes C142 of each solar cell.

Further, the second interconnector CW2 may be electrically connected to the second finger electrodes C142 of each solar cell using the conductive adhesive CP and may be insulated from the first finger electrodes C141 of each solar cell.

The intercell connector CC may be connected to the first interconnector CW1 connected to the first finger electrodes C141 of the first solar cell C1 and the second interconnector CW2 connected to the second finger electrodes C142 of the second solar cell C2, thereby electrically connecting the first solar cell C1 and the second solar cell C2 in series.

Even in the solar cell module having the above-described structure according to the second embodiment of the invention, the insulating adhesive portions AT1 and AT2 may be used to temporarily fix the interconnectors CW1 and CW2 to be connected to each solar cell to the back surface of the semiconductor substrate 110.

For example, as shown in FIG. 15, the insulating adhesive portions AT1 and AT2 may be positioned in both areas of each semiconductor substrate 110 and may extend in the second direction Y-Y' crossing the interconnectors CW1 and CW2.

Further, as shown in FIGS. 13 and 14, one insulating adhesive portion may be used in each solar cell, or the plurality of insulating adhesive portions may be dividedly positioned in the second direction Y-Y'.

## Claims

1. A solar cell module comprising:
a plurality of solar cells (C1, C2) each including a semiconductor substrate (110) with a front and a back surface and first and second electrodes (C141, C142) each having a different polarity and provided alternately on the back surface, respectively;
a plurality of interconnectors (CW1, CW2) electrically connected to the plurality of solar cells;
a conductive adhesive (CP) electrically connecting each of the plurality of interconnectors to the corresponding electrodes of each of the plurality of solar cells; and
a plurality of insulating adhesive portions (AT),
**characterized in that**
the plurality of interconnectors include first interconnectors (CW1) disposed on and connected to the first electrodes of a first solar cell (C1) and second interconnectors (CW2) disposed on and connected to the second electrodes of the first solar cell (C1), the first and second interconnectors extending in a first direction (x-x'),
the first and second electrodes (C141, C142) extend in a second direction (y-y') crossing the first direction (x-x'),
the plurality of insulating adhesive portions (AT) extends in the second direction (y-y') in parallel to and contiguous to the first and second electrodes (C141, C142) and is positioned on the plurality of interconnectors disposed on a back surface of each of the plurality of solar cells (C1, C2), respectively,
and the plurality of insulating adhesive portions (AT) is formed of a single-sided tape and is positioned on the plurality of interconnectors so that an adhesive side of the plurality of insulating adhesive portions (AT) faces the semiconductor substrate (110).

2. The solar cell module of claim 1, wherein the plurality of insulating adhesive portions includes a first tape (AT1) positioned at one edge of the semiconductor substrate and a second tape (AT2) positioned at an opposite edge to the one edge of the semiconductor substrate.

3. The solar cell module of claim 1, wherein the plurality of insulating adhesive portions includes a third tape (AT3) positioned between the first tape (AT1) and the second tape (AT2).

4. The solar cell module of claims 1 to 3, wherein a width of the plurality of insulating adhesive portions (AT) is greater than a width of the plurality of interconnectors; or
wherein a width of the plurality of insulating adhesive portions (AT) is equal to or less than a width of the plurality of interconnectors.

5. The solar cell module of claim 2 or of any one of claims 3 to 4 when dependent on claim 2, wherein at least one of the first tape (AT1) or the second tape (AT2) is divided into a plurality of parts along the second direction.

6. The solar cell module of claims 1 to 5, wherein the plurality of solar cells include a first solar cell (C1) and a second solar cell (C2) adjacent to each other, and
the first interconnectors (CW1) connected to the first electrodes (C141) of the first solar cell (C1) are connected to the second electrodes (C142) of the second solar cell (C2) and the second interconnectors (CW2) connected to the second electrodes (C142) of the first solar cell (C1) are connected to the first electrodes (C141) of the second solar cell (C2).

7. The solar cell module of claim 6, wherein the first interconnector (CW1) connected to the first solar cell (C1) and the second interconnector (CW2) connected to the second solar cell (C2) are connected to an intercell connector (CC) positioned between the two adjacent solar cells and extending in the second direction.

## Patentansprüche

1. Solarzellenmodul, umfassend:
eine Mehrzahl von Solarzellen (C1, C2), die jeweils ein Halbleitersubstrat (110) mit einer vorderen und einer hinteren Oberfläche und ersten und zweiten Elektroden (C141, C142), die jeweils eine unterschiedliche Polarität aufweisen und alternierend auf der hinteren Oberfläche angeordnet ist, umfassen;
eine Mehrzahl von Verbindungsleitungen (CW1, CW2), die elektrisch mit der Mehrzahl von Solarzellen verbunden ist;
ein leitfähiges Adhäsiv (CP), das jede der Mehrzahl von Verbindungsleitungen mit den entsprechenden Elektroden von jeder der Mehrzahl von Solarzellen elektrisch verbindet; und
eine Mehrzahl von isolierenden Adhäsivabschnitten (AT),
**dadurch gekennzeichnet, dass**
die Mehrzahl von Verbindungsleitungen erste Verbindungsleitungen (CW1) enthält, die auf den ersten Elektroden einer ersten Solarzelle (C1) angeordnet und mit diesen verbunden sind, und zweite Verbindungsleitungen (CW2) enthält, die auf den zweiten Elektroden der ersten Solarzelle (C1) angeordnet und mit diesen verbunden sind, wobei sich die ersten und zweiten Verbindungsleitungen in einer ersten Richtung (x-x') erstrecken,
die ersten und zweiten Elektroden (C141, C142) sich in einer zweiten Richtung (y-y') erstrecken, welche die erste Richtung (x-x') kreuzt,
die Mehrzahl von isolierenden Adhäsivabschnitten (AT) sich in der zweiten Richtung (y-y') parallel zu und angrenzend an die ersten und zweiten Elektroden (C141, C142) erstreckt und auf der Mehrzahl von Verbindungsleitungen angeordnet ist, die jeweils auf einer hinteren Oberfläche jeder der Mehrzahl von Solarzellen (C1, C2) angeordnet ist,
und die Mehrzahl von isolierenden Adhäsivabschnitten (AT) aus einem einseitigen Klebeband gebildet ist und auf der Mehrzahl von Verbindungsleitungen so angeordnet ist, dass eine Adhäsivseite der Mehrzahl von isolierenden Adhäsivabschnitten (AT) dem Halbleitersubstrat (110) zugewandt ist.

2. Solarzellenmodul nach Anspruch 1, wobei die Mehrzahl von isolierenden Adhäsivabschnitten ein erstes Klebeband (AT1) enthält, das an einem Rand des Halbleitersubstrats angeordnet ist, und ein zweites Klebeband (AT2) enthält, das an einem Rand angeordnet ist, die dem einen Rand des Halbleitersubstrats gegenüberliegt.

3. Solarzellenmodul nach Anspruch 1, wobei die Mehrzahl von isolierenden Adhäsivabschnitten ein drittes Klebeband (AT3) umfasst, das zwischen dem ersten Klebeband (AT1) und dem zweiten Klebeband (AT2) angeordnet ist.

4. Solarzellenmodul nach Ansprüchen 1 bis 3, wobei eine Breite der Mehrzahl von isolierenden Adhäsivabschnitten (AT) größer ist, als eine Breite der Mehrzahl von Verbindungsleitungen; oder
wobei eine Breite der Mehrzahl von isolierenden Adhäsivabschnitten (AT) gleich einer oder kleiner ist, als eine Breite der Mehrzahl von Verbindungsleitungen.

5. Solarzellenmodul nach Anspruch 2 oder nach einem beliebigen der Ansprüche 3 bis 4, wenn diese von Anspruch 2 abhängig sind, wobei mindestens das erste Klebeband (AT1) oder das zweite Klebeband (AT2) in eine Mehrzahl von Abschnitte entlang der zweiten Richtung unterteilt ist.

6. Solarzellenmodul nach Ansprüchen 1 bis 5, wobei die Mehrzahl von Solarzellen eine erste Solarzelle (C1) und eine zweite Solarzelle (C2), die aneinander angrenzen, enthält, und
die ersten Verbindungsleitungen (CW1), die mit den ersten Elektroden (C141) der ersten Solarzelle (C1) verbunden sind, mit den zweiten Elektroden (C142) der zweiten Solarzelle (C2) verbunden sind und die zweiten Verbindungsleitungen (CW2), die mit den zweiten Elektroden (C142) der ersten Solarzelle (C1) verbunden sind, mit den ersten Elektroden (C141) der zweiten Solarzelle (C2) verbunden sind.

7. Solarzellenmodul nach Anspruch 6, wobei die mit der ersten Solarzelle (C1) verbundene erste Verbindungsleitung (CW1) und die mit der zweiten Solarzelle (C2) verbundene zweite Verbindungsleitung (CW2) mit einem Zwischenzellenverbinder (CC) verbunden sind, der zwischen den zwei angrenzenden Solarzellen angeordnet ist und sich in die zweite Richtung erstreckt.

## Revendications

1. Module de cellules solaires comprenant :
une pluralité de cellules solaires (C1, C2) chacune comprenant un substrat semi-conducteur (110) ayant une face avant et une face arrière et des premières et secondes électrodes (C141, C142) chacune ayant une polarité différente et disposées en alternance sur la face arrière, respectivement ;
une pluralité d'interconnecteurs (CW1, CW2) connectés électriquement à la pluralité de cellules solaires ;
un adhésif conducteur (CP) connectant électriquement chaque interconnecteur de la pluralité d'interconnecteurs aux électrodes correspondantes de chaque cellule solaire de la pluralité de cellules solaires ;
et
une pluralité de parties d'adhésif isolant (AT),
**caractérisé en ce que**
la pluralité des interconnecteurs comprenant des premiers interconnecteurs (CW1) disposés sur et connectés aux premières électrodes d'une première cellule solaire (C1) et des seconds interconnecteurs (CW2) disposés sur les secondes électrodes de la première cellule solaire (C1) et connectés à celles-ci, les premiers et les seconds interconnecteurs s'étendant dans une première direction (x-x),
les premières et secondes électrodes (C141, C142) s'étendent dans une seconde direction (y-y) croisant la première direction (x-x'),
la pluralité des parties d'adhésif isolant (AT) s'étendent dans la seconde direction (y-y') parallèlement et de manière adjacente aux premières et secondes électrodes (C141, C142) et sont positionnées sur la pluralité des interconnecteurs disposés sur une face arrière de chaque cellule solaire de la pluralité des cellules solaires (C1, C2), respectivement,
et la pluralité des parties d'adhésif isolant (AT) est formée sur un ruban monoface et est positionnée sur la pluralité des interconnecteurs de sorte qu'un côté adhésif de la pluralité des parties d'adhésif isolant (AT) fait face au substrat semi-conducteur (110).

2. Module de cellules solaires selon la revendication 1, la pluralité des parties d'adhésif isolant comprenant un premier ruban (AT1) positionné sur un bord du substrat semi-conducteur et un deuxième ruban (AT2) positionné sur un bord en regard du bord du substrat semi-conducteur.

3. Module de cellules solaires selon la revendication 1, la pluralité des parties d'adhésif isolant comprenant un troisième ruban (AT3) positionné entre le premier ruban (AT1) et le deuxième ruban (AT2).

4. Module de cellules solaires selon les revendications 1 à 3, une largeur de la pluralité des parties d'adhésif isolant (AT) étant supérieure à une largeur de la pluralité des interconnecteurs ; ou
une largeur de la pluralité des parties d'adhésif isolant (AT) étant inférieure ou égale à une largeur de la pluralité des interconnecteurs.

5. Modules de cellules solaires selon la revendication 2 ou l'une quelconque des revendications 3 à 4, lorsqu'elle relève de la revendication 2, au moins le premier ruban (AY1) ou le second ruban (AT2) étant divisé en une pluralité de parties dans la seconde direction.

6. Module de cellules solaires selon les revendications 1 à 5, la pluralité des cellules solaires comprenant une première cellule solaire (C1) et une seconde cellule solaire (C2) adjacentes l'une à l'autre, et
les premiers interconnecteurs (CW1) connectés aux premières électrodes (C141) de la première cellule solaire (C1) sont connectés aux secondes électrodes (C142) de la seconde cellule solaire (C2) et les seconds interconnecteurs (CW2) connectés aux secondes électrodes (C142) de la première cellule solaire (C1) sont connectés aux premières électrodes (C141) de la seconde cellule solaire (C2).

7. Module de cellules solaires selon la revendication 6, le premier interconnecteur (CW1) connecté à la première cellule solaire (C1) et le second interconnecteur (CW2) connecté à la seconde cellule solaire (C2) étant connectés à un connecteur intercellulaire (CC) positionné entre les deux cellules solaires adjacentes et s'étendant dans la seconde direction.
